# EUROPEAN PATENT APPLICATION

(11) **EP 4 832 724 A1**
(43) Date of publication of application: **28.10.2026**
(21) Application number: 26201853.4
(22) Date of filing: 29.08.2026
(51) Int. Cl.: H10K 59/80

(54) **DISPLAY PANEL AND DISPLAY DEVICE**

(30) Priority: 27.04.2026 CN 202610564993
(71) Applicant: Wuhan China Star Optoelectronics Semiconductor Display Technology Co., Ltd., Wuhan, Hubei 430079 (CN)
(72) Inventor: YU, Haijun, Wuhan, 430079 (CN); CHEN, Junsong, Wuhan, 430079 (CN); YAN, Longfei, Wuhan, 430079 (CN); WU, Rusong, Wuhan, 430079 (CN)
(74) Representative: Zhu, Puxing

(57) **Abstract**

A display panel and a display device are provided. The thickness of the encapsulation layer decreases in the direction from the central display region to the edge of the edge display region. In any two adjacent edge sub-regions, the width of the anti-peeping opening of the first anti-peeping pixel in the edge sub-region away from the central display region is smaller than the width of the anti-peeping opening of the first anti-peeping pixel in the edge sub-region close to the central display region; and the widths of the anti-peeping openings of the first anti-peeping pixels located in the same edge sub-region are the same. In the embodiments of the invention, the first edge region, the corner transition region and the second edge region are regarded as a whole which is divided into a plurality of edge sub-regions, and the edge sub-region having lower height is provided with the first anti-peeping pixel having smaller anti-peeping opening, the anti-peeping openings of the first anti-peeping pixels in the same edge sub-region are the same, so as to improve uniformity of display transition between the first edge region and the second edge region and reduce risk of bright-dark boundary caused by non-uniform transition.

## Description

### TECHNICAL FIELD

The invention relates to the field of display technologies, and in particular, to a display panel and a display device.

### BACKGROUND

The design principle of active anti-peeping for organic light-emitting diode displays is as follows. When pixels are designed, the light-emitting pixels are divided into anti-peeping pixels and shared pixels. The anti-peeping pixel adopts a unique design so that its brightness decays very quickly at a large viewing angle.

Specifically, the light shielding is mainly realized by the difference in two black matrix layers. The lower black matrix layer determines the light emission of the shared pixels, and in the anti-peeping region, a height elevating layer and an upper black matrix layer are disposed above the lower black matrix layer. The height elevating layer elevates the upper black matrix layer to realize the shielding of light emission at small angle of the anti-peeping pixel, while light emission at large-angle is shielded by the lower black matrix layer. In this way, brightness of the anti-peeping pixels can rapidly decay with increasing viewing angle, thereby achieving the effect of anti-peeping.

However, due to the influence of the existing package process, when the organic encapsulation layer is prepared, the thickness of the organic encapsulation layer located in the display edge region is smaller than the thickness of the organic encapsulation layer located in the display central region. As a result, the height of the upper black matrix layer located in the display edge region is lower than the height of the upper black matrix layer located in the display central region. Due to the fact that upper black matrix layer located in the display edge region has a lower height, when the anti-peeping pixels are viewed at a certain angle, the display central region has good anti-peeping effect and low brightness, while the display edge region has poor anti-peeping effect and high brightness, resulting in that the display edge region has poor anti-peeping effect and high brightness, which affect the anti-peeping effect and display effect.

### SUMMARY

Embodiments of the invention provide a display panel and a display device, to solve the above technical problem.

In order to achieve the above object, according to a first aspect of the invention, a display panel is provided, including:
a light-emitting pixel layer including a plurality of anti-peeping pixels, wherein each of the anti-peeping pixels includes a plurality of anti-peeping sub-pixels;
an encapsulation layer covering a light-emitting side of the light-emitting pixel layer; and
at least one light-shielding layer disposed on a side of the encapsulation layer away from the light-emitting pixel layer, wherein one of the at least one light-shielding layer is configured to shield part of emitted light of the anti-peeping sub-pixels, and the light-shielding layer is provided with a plurality of anti-peeping openings, each of the anti-peeping sub-pixels is corresponded to one of the anti-peeping openings, and a width of each of the anti-peeping openings is a dimension along a first direction;
wherein the display panel includes a central display region and an edge display region, the edge display region is disposed at a periphery of the central display region, the edge display region includes a first edge region, a second edge region, and at least one corner transition region; wherein the first edge region extends along the first direction and is located at one side of the central display region in a second direction, the second edge region extends along the second direction and is located at one side of the central display region in the first direction, the corner transition region connects the first edge region with the second edge region, and the first direction is intersected with the second direction;
wherein the edge display region includes a plurality of edge sub-regions, the edge sub-regions are arranged along a direction from the central display region to an edge of the edge display region, a part of one of the edge sub-regions is located in the first edge region, another part of the edge sub-region is located in the corner transition region, and a further other part of the edge sub-region is located in the second edge region; and
wherein the anti-peeping pixels comprise a plurality of first anti-peeping pixels, each of the first anti-peeping pixels is completely disposed in one of the edge sub-regions; wherein a thickness of the encapsulation layer decreases in the direction from the central display region to the edge of the edge display region, and in any two adjacent ones of the edge sub-regions, a width of an anti-peeping opening corresponding to one of the first anti-peeping pixels in one of the two adjacent edge sub-regions away from the central display region is smaller than a width of an anti-peeping opening corresponding to one of the first anti-peeping pixels in one of the two adjacent edge sub-regions close to the central display region, and widths of anti-peeping openings corresponding to ones of the first anti-peeping pixels located in a same one of the edge sub-regions are same.

Optionally, in some embodiments of the invention, the anti-peeping pixels include a plurality of second anti-peeping pixels, wherein each of the second anti-peeping pixels is disposed in both two adjacent ones of the edge sub-regions, and a width of an anti-peeping opening corresponding to one of the first anti-peeping pixels in one of the two adjacent edge sub-regions is same as a width of an anti-peeping opening corresponding to the second anti-peeping pixel.

Optionally, in some embodiments of the invention, the second anti-peeping pixels include an offset anti-peeping pixel, a center of the offset anti-peeping pixel is disposed in one of the two adjacent edge sub-regions, and in the same edge sub-region, a width of an anti-peeping opening corresponding to the offset anti-peeping pixel is same as the width of the anti-peeping opening corresponding to the first anti-peeping pixel.

Optionally, in some embodiments of the invention, the second anti-peeping pixels include a middle anti-peeping pixel, and a center of the middle anti-peeping pixel is disposed on a boundary line between the two adjacent edge sub-regions; in the two adjacent edge sub-regions, a width of an anti-peeping opening corresponding to one of the first anti-peeping pixels in one of the two adjacent edge sub-regions away from the central display region is same as a width of an anti-peeping opening corresponding to the middle anti-peeping pixel.

Optionally, in some embodiments of the invention, a height of a surface on a side of the light-shielding layer provided with the anti-peeping openings close to the encapsulation layer decreases along the direction from the central display region to the edge of the edge display region; and
wherein the surface on the side of the light-shielding layer provided with the anti-peeping openings close to the encapsulation layer has a plurality of contour lines, and boundary lines of the edge sub-regions are the contour lines.

Optionally, in some embodiments of the invention, heights of the boundary lines of the edge sub-regions decrease in the direction from the central display region to the edge of the edge display region; and two adjacent ones of the edge sub-regions have a same boundary line.

Optionally, in some embodiments of the invention, two adjacent ones of the boundary lines of the edge sub-regions has a height difference, and a height difference between any two ones of the boundary lines of the edge sub-regions is consistent in the direction from the central display region to the edge of the edge display region; or,
wherein two adjacent ones of the boundary lines of the edge sub-regions has a height difference, and the height difference between the two adjacent boundary lines of the edge sub-regions increases in the direction from the central display region to the edge of the edge display region.

Optionally, in some embodiments of the invention, the display panel includes a blocking wall, the blocking wall extends along a periphery of the edge display region, the encapsulation layer includes an organic encapsulation layer, and the blocking wall is configured to block the organic encapsulation layer; and
wherein in the direction from the central display region to the edge of the edge display region, two adjacent ones of the edge sub-regions have a same boundary line, and the boundary line of the two adjacent edge sub-regions is parallel to an extension trajectory of the blocking wall.

Optionally, in some embodiments of the invention, a width of the first edge region is greater than a width of the second edge region, and the edge display region further includes an irregularly shaped sub-region; wherein a part of the irregularly shaped sub-region is located in the corner transition region, another part of the irregularly shaped sub-region is located in the first edge region, and the irregularly shaped sub-region is disposed outside the second edge region; wherein the irregularly shaped sub-region shares a boundary line with the central display region, and the irregularly shaped sub-region shares another boundary line with an adjacent one of the edge sub-regions, and some of the first anti-peeping pixels of the anti-peeping pixels are completely disposed in the irregularly shaped sub-region; and
wherein a width of an anti-peeping opening corresponding to one of the first anti-peeping pixels in the irregularly shaped sub-region is greater than a width of an anti-peeping opening corresponding to one of the first anti-peeping pixels in the edge sub-regions, and the width of the anti-peeping opening corresponding to the first anti-peeping pixel in the irregularly shaped sub-region is less than a width of an anti-peeping opening corresponding to one of the anti-peeping pixels in the central display region.

Optionally, in some embodiments of the invention, in two adjacent ones of the edge sub-regions, a width of one of the two adjacent edge sub-regions away from the central display region is less than a width of one of the two adjacent edge sub-regions close to the central display region.

Optionally, in some embodiments of the invention, in the two adjacent edge sub-regions, a number of anti-peeping openings and a number of anti-peeping sub-pixels in one of the two adjacent edge sub-regions away from the central display region is less than a number of anti-peeping openings and a number of anti-peeping sub-pixels in one of the two adjacent edge sub-regions close to the central display region.

Optionally, in some embodiments of the invention, the edge display region includes a third edge region and a fourth edge region; wherein the third edge region extends along the first direction, and the fourth edge region extends along the second direction;
wherein the fourth edge region is located at a side of the central display region away from the second edge region in the first direction, the third edge region is located at a side of the central display region away from the first edge region in the second direction; wherein the second edge region and the third edge region, the third edge region and the fourth edge region, and the fourth edge region and the first edge region, are respectively connected by one of the at least one corner transition region; and
wherein one of the edge sub-regions is a closed ring shape, a first part of the edge sub-region is located in the first edge region, a second part of the edge sub-region is located in the second edge region, a third part of the edge sub-region is located in the third edge region, a fourth part of the edge sub-region is located in the fourth edge region, and one fifth part of the edge sub-region is correspondingly located in one of the at least one corner transition region.

Optionally, in some embodiments of the invention, widths of all anti-peeping openings in a same one of the anti-peeping pixels are same.

Optionally, in some embodiments of the invention, the display panel includes a spacer layer, the at least one light-shielding layer includes a first light-shielding layer and a second light-shielding layer, the first light-shielding layer is disposed on a side of the encapsulation layer away from the light-emitting pixel layer, the first light-shielding layer is configured to block part of the emitted light of the anti-peeping sub-pixels; wherein the spacer layer covers a side of the first light-shielding layer away from the light-emitting pixel layer; the second light-shielding layer is disposed on a surface at a side of the spacer layer away from the light-emitting pixel layer, and the second light-shielding layer is provided with the anti-peeping openings; and
wherein the first light-shielding layer is provided with a plurality of first openings, one of the first openings is correspondingly aligned with one of the anti-peeping openings in a thickness direction of the display panel, and a width of each of the first openings is along the first direction; wherein widths of the first openings decrease in the direction from the central display region to the edge display region.

Optionally, in some embodiments of the invention, in the first opening and the anti-peeping opening which are aligned with each other, a decrease extent in width of the first opening is same as a decrease extent in width of the anti-peeping opening in a direction from the central display region to a non-display region of the display panel.

Optionally, in some embodiments of the invention, the light-emitting pixel layer includes a shared pixel, wherein the shared pixel includes a plurality of shared sub-pixels, the first light-shielding layer is provided with a plurality of second openings, and one of the second openings is corresponded to one of the shared sub-pixels in a thickness direction of the display panel; and
a width of each of the second openings is along the first direction, and the width of the second opening decreases in the direction from the central display region to the edge display region.

According to a second aspect of the invention, a display device is provided, which includes the display panel in any one of the embodiments described above.

In the display panel and the display device of embodiments of the invention, the edge display region is provided with a plurality of edge sub-regions. The plurality of edge sub-regions are arranged along a direction from the central display region to the edge of the edge display region. A part of one of the edge sub-regions is located in the first edge region, another part of the edge sub-region is located in the corner transition region; and another part of the edge sub-region is located in the second edge region.
wherein the anti-peeping pixels include a plurality of first anti-peeping pixels, each of the first anti-peeping pixels is completely disposed in one of the edge sub-regions; in the direction from the central display region to the edge of the edge display region, a thickness of the encapsulation layer decreases, and in any two adjacent ones of the edge sub-regions, a width of an anti-peeping opening corresponding to one of the first anti-peeping pixels in the edge sub-region away from the central display region is smaller than a width of an anti-peeping opening corresponding to one of the first anti-peeping pixels in the edge sub-region close to the central display region, and widths of anti-peeping openings corresponding to first anti-peeping pixels of the first anti-peeping pixels located in a same edge sub-region are same.

It can be understood that, in the display panel and the display device of embodiments of the invention, the first edge region, the corner transition region and the second edge region are regarded as a whole which is divided into a plurality of edge sub-regions, and the edge sub-region having lower height is provided with the first anti-peeping pixel having smaller anti-peeping opening, the anti-peeping openings of the first anti-peeping pixels in the same edge sub-region are the same, so as to improve uniformity of display transition between the first edge region and the second edge region and reduce risk of bright-dark boundary caused by non-uniform transition.

Other features and advantages of the invention will be described in detail in the following description.

### BRIEF DESCRIPTION OF THE DRAWINGS

In order to explain the embodiments of the invention more clearly, the accompanying drawings required in the description of the embodiments will be briefly introduced below. It is apparent that the accompanying drawings in the following description are merely some of the embodiments of the invention, and other drawings may be obtained on the basis of these drawings by those skilled in the art without involving any inventive effort.

In order to fully understand the invention and beneficial effects thereof, the description will be given below in conjunction with the drawings, wherein the same reference numbers in the description below indicate the same parts in the drawings.
FIG. 1 is a schematic diagram of a planar top viewing structure of a display panel according to some exemplary embodiments of the invention;
FIG. 2 is a schematic diagram of a cross-sectional structure of a display panel according to some exemplary embodiments of the invention;
FIG. 3 is a schematic diagram of a partial cross-sectional structure of an edge display region and a central display region in a display panel according to some exemplary embodiments of the invention;
FIG. 4 is a schematic enlarged view of part M in FIG. 1.
FIG. 5 is a schematic enlarged view of part N in FIG. 1.
FIG. 6 is a partial enlarged view of FIG. 5;
FIG. 7 is another schematic enlarged view of part N in FIG. 1;
FIG. 8 is a partial enlarged view in FIG. 7;
FIG. 9 is another enlarged view of part N in FIG. 1; and
FIG. 10 is a schematic diagram of a structure of a display device according to some exemplary embodiments of the invention.

### Description of reference numerals:

Display Panel-100; First Direction-F1; Second Direction-F2; Display Region-DA; Non-Display Region-NDA; Central Display Region-A1; Edge Display Region-A2; First Edge Region-A21; Second Edge Region-A22; Third Edge Region-A23; Fourth Edge Region-A24; Corner Transition Region-A25; Opening Edge Region-A26; Opening Region-KK; Pixel Definition Layer-101; Light-Emitting Pixel Layer-102; Encapsulation Layer-103; Light-Shielding Layer-ZG; First Inorganic Encapsulation Layer-03a; Organic Encapsulation Layer-03b; Second Inorganic Encapsulation Layer-03c; First Light-Shielding Layer-104; Spacer Layer-105; First Organic Layer-05a; Second Organic Layer-05b; Second Light-Shielding Layer-106; Touch Structure Layer-107; First Touch Insulation Layer-07a; Second Touch Insulation Layer-07b; Planarization Layer-108; Protection Layer-109; Anti-Peeping Pixel-U1; Shared Pixel-U2; Anti-Peeping Sub-Pixel-P1; Shared Sub-Pixel-P2; First Sub-Pixel-G1; Second Sub-Pixel-R1; Third Sub-Pixel-B1; Center-Q; Anti-Peeping Opening-06a; Edge Sub-Region-Z1; First Anti-Peeping Pixel-1u; Second Anti-Peeping Pixel-2u; Offset Anti-Peeping Pixel-2u1; Boundary Line-BJ; Anti-Peeping Portion-061; First Anti-Peeping Portion-61a; Second Anti-Peeping Portion-61b; Contour Line-DG; First Opening-04a; Second Opening-04b; First Light-Shielding Portion-041; First Pixel Opening-S1; Second Pixel Opening-S2; Blocking wall-110; Irregularly shaped sub-region-Z2; Extension Trajectory-GJ; Display Device-1000.

### DETAILED DESCRIPTION

In the following, the embodiments of the invention will be clearly and completely described with reference to the accompanying drawings. It is apparent that the described embodiments are only part, rather than all of the embodiments of the invention. Based on the embodiments in the invention, all other embodiments obtained by those skilled in the art without involving any inventive effort are within the scope of the invention.

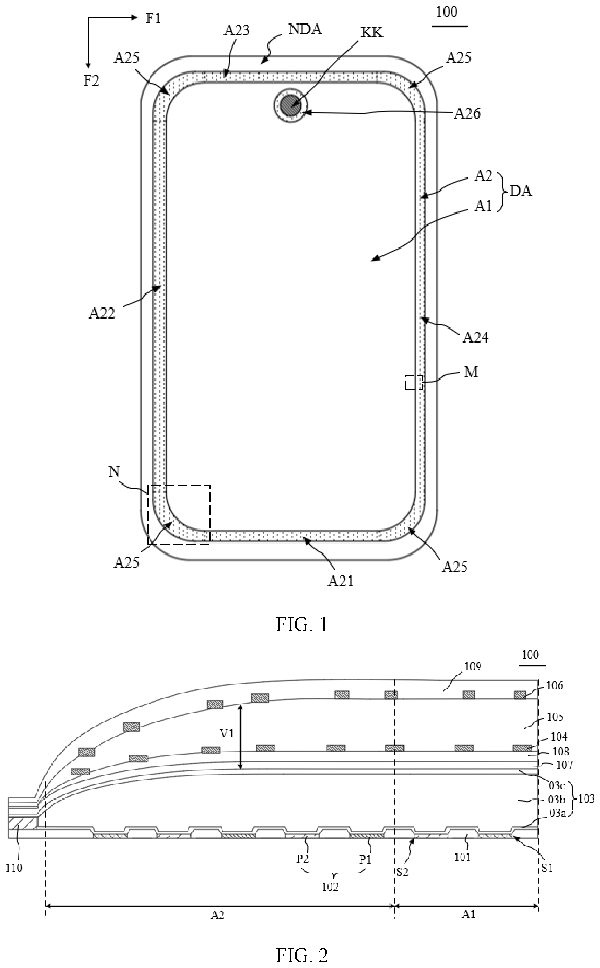

The invention provides a display panel 100. Referring to FIG. 1 and FIG. 2, FIG. 1 is a schematic diagram of a planar top viewing structure of a display panel 100 according to some exemplary embodiments of the invention; and FIG. 2 is a schematic diagram of a cross-sectional structure of a display panel 100 according to some exemplary embodiments of the invention.

In FIG. 1, the first direction F1 may be a direction parallel to one side of the display panel 100 in a planar view, and may be, for example, a lateral direction of the display panel 100. The second direction F2 may be a direction parallel to another side of the display panel 100 in the planar view, and may be the longitudinal direction of the display panel 100.

The display panel 100 may have a rectangular shape or a square shape in the planar view, but the embodiments are not limited thereto. In some embodiments, the display panel 100 may have a rectangular shape with perpendicular corners or rounded corners in the planar view. As shown in FIG. 1, the display panel 100 has a rectangular shape with rounded corners.

The display panel 100 may include two short sides arranged in the first direction F1 and two long sides arranged in the second direction F2 in the planar view.

The display panel 100 includes a display region DA and a non-display region NDA. In the planar view, the shape of the display region DA may correspond to the shape of the display panel 100. For example, in a case where the display panel 100 has a rectangular shape in the planar view, the display region DA may also have a rectangular shape.

The non-display region NDA may be arranged at the vicinity (or periphery) of the display region DA. As shown in FIG. 1, the non-display region NDA may surround the display region DA, which is not limited in the embodiments.

Optionally, in some embodiments of the invention, the display region DA includes a central display region A1 and an edge display region A2. The edge display region A2 is disposed at the periphery side of the central display region A1.

Optionally, in some embodiments of the invention, the edge display region A2 includes a first edge region A21, a second edge region A22, a third edge region A23, a fourth edge region A24, the corner transition regions A25 and an opening edge region A26. The first edge region A21 and the third edge region A23 extend along the first direction F1, and the second edge region A22 and the fourth edge region A24 extend along the second direction F2 intersected with the first direction F1.

Optionally, the first direction F1 is perpendicular to the second direction F2.

The display panel 100 is provided with an opening region KK, and the opening region KK is configured to be transmitted by the ambient light. The opening edge region A26 surrounds the periphery of the opening region KK, and the central display region A1 surrounds the periphery of the opening edge region A26.

In the first direction F1, the second edge region A22 is located at one side of the central display region A1, and the fourth edge region A24 is located at another side of the central display region A1. In the second direction F2, the first edge region A21 is located at one end of the central display region A1, and the third edge region A23 is located at another end of the central display region A1. The first edge region A21 and the second edge region A22, the second edge region A22 and the third edge region A23, the third edge region A23 and the fourth edge region A24, and the fourth edge region A24 and the first edge region A21 are respectively connected through a corner transition region A25.

Optionally, the corner transition region A25 includes but is not limited to an arc-shaped region, for example, it can be a circular arc region or an irregular region.

Optionally, in some embodiments of the invention, the display panel 100 according to the embodiments of the invention includes a pixel definition layer 101, a light-emitting pixel layer 102, an encapsulation layer 103, and at least one light-shielding layer ZG.

The light-emitting pixel layer 102 includes a plurality of anti-peeping pixels U1. The anti-peeping pixel U1 includes a plurality of anti-peeping sub-pixels P1. The encapsulation layer 103 covers the light-emitting side of the light-emitting pixel layer 102. At least one light-shielding layer ZG is disposed on a side of the encapsulation layer 103 away from the light-emitting pixel layer 102. The light-shielding layer ZG is configured to shield a part of light emitting from the anti-peeping sub-pixel P1. The light-shielding layer ZG is provided with a plurality of anti-peeping openings 06a, and each anti-peeping sub-pixel P1 is corresponded to one anti-peeping opening 06a.

It should be noted that the anti-peeping opening corresponding to the sub-pixel is an anti-peeping opening in alignment with a sub-pixel in a thickness direction of the display panel 100.

It may be understood that at least one light-shielding layer ZG can be only one light-shielding layer ZG, or two or more layers of light-shielding layers ZG.

Optionally, in some embodiments of the invention, the display panel 100 includes a spacer layer 105. The at least one light-shielding layer ZG includes a first light-shielding layer 104 and a second light-shielding layer 106, and the first light-shielding layer 104 is disposed on a side of the encapsulation layer 103 away from the light-emitting pixel layer 102. The first light-shielding layer 104 is configured to shield a part of emitting light of the anti-peeping sub-pixel P1. The spacer layer 105 cover a side of the first light-shielding layer 104 away from the light-emitting pixel layer 102, and the second light-shielding layer 106 is disposed on a surface of the spacer layer 105 away from the light-emitting pixel layer 102. The second light-shielding layer 106 is provided with an anti-peeping opening 06a.

Optionally, in some embodiments of the invention, the pixel definition layer 101 is disposed on the circuit layer. The pixel definition layer 101 is provided with a plurality of pixel openings, and the light-emitting pixel layer 102 is disposed in the pixel openings. The encapsulation layer 103 covers the light-emitting side of the light-emitting pixel layer 102. The first light-shielding layer 104 is disposed on a side of the encapsulation layer 103 away from the light-emitting pixel layer 102, and the first light-shielding layer 104 is configured to shield a part of emitting light of the anti-peeping sub-pixel P1. The spacer layer 105 covers a side of the first light-shielding layer 104 away from the light-emitting pixel layer 102. The second light-shielding layer 106 is disposed on a surface of the spacer layer 105 away from the light-emitting pixel layer 102.

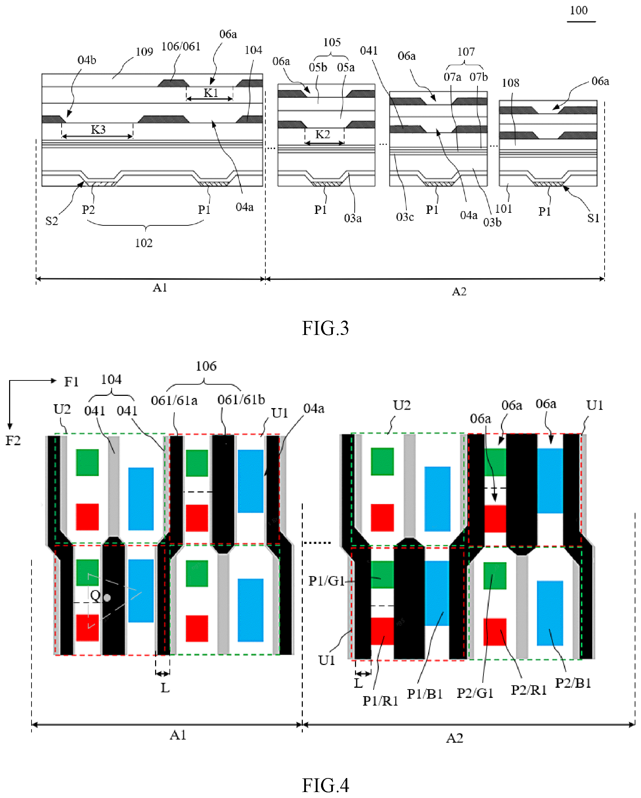

Optionally, in some embodiments, as shown in FIG. 3, the display panel 100 further includes a touch structure layer 107, a planarization layer 108 and a protection layer 109. The touch structure layer 107 is disposed on the encapsulation layer 103, and the planarization layer 108 covers the touch structure layer 107. The first light-shielding layer 104 is disposed on a side of the planarization layer 108 away from the light-emitting pixel layer 102. The protection layer 109 covers the second light-shielding layer 106.

Optionally, the circuit layer includes a pixel circuit, and the pixel circuit is configured to drive the light-emitting pixel layer 102 to emit light.

Optionally, in some embodiments, the color of the pixel definition layer 101 is black, so as to improve display contrast. The pixel definition layer 101 is provided with a plurality of first pixel openings S1. The anti-peeping sub-pixel P1 is disposed in the first pixel opening S1.

Optionally, the light-emitting pixel layer 102 includes an organic light-emitting layer. In some embodiments, the organic light-emitting layer includes a bottom electrode, a hole injection layer, a hole transport layer, an organic light-emitting material layer, an electron transport layer, an electron injection layer and a counter electrode that are stacked.

Optionally, the bottom electrode is an anode, and the counter electrode is a cathode.

Optionally, the encapsulation layer 103 includes a first inorganic encapsulation layer 03a, an organic encapsulation layer 03b and a second inorganic encapsulation layer 03c that are stacked. In the edge display region A2, the thickness of the organic encapsulation layer 03b decreases in a direction from the central display region A1 to the non-display region NDA.

Optionally, the thickness of the first inorganic encapsulation layer 03a ranges from 1 micron to 1.5 microns, for example, it is 1 micron, 1.1 microns, 1.2 microns, 1.3 microns, 1.4 microns or 1.5 microns. The thickness of the second inorganic encapsulation layer 03c ranges from 0.6 microns to 0.8 microns, for example, it can be 0.6 microns, 0.7 microns or 0.8 microns.

Optionally, the touch structure layer 107 includes a first touch insulation layer 07a, a second touch insulation layer 07b and a touch electrode. The touch electrode is disposed between the first touch insulation layer 07a and the second touch insulation layer 07b, but is not limited thereto. In some embodiments, the touch electrode is disposed on a side of the first touch insulation layer 07a and the second touch insulation layer 07b close to the encapsulation layer 103.

Optionally, the planarization layer 108 is configured to elevate the first light-shielding layer 104 and the second light-shielding layer 106. The planarization layer 108 is made of a material with high leveling property, and has a thickness ranging from 4 microns to 6 microns. For example, the thickness may be 4 microns, 5 microns or 6 microns.

Optionally, the first light-shielding layer 104 and the second light-shielding layer 106 may be made of an inorganic metal material, such as Cr, Mo or Mn; or a metal oxide material, such as CrOx, MoOx or MnO₂; or a mixed film formed by a metal and a metal oxide; or an organic black resin material, such as black polystyrene or black photoresist.

Optionally, the first light-shielding layer 104 and the second light-shielding layer 106 are made of a black light-absorbing material.

Optionally, the thickness of the first light-shielding layer 104 ranges from 0.9 microns to 1.2 microns, for example, 0.9 microns, 1.0 microns, 1.1 microns or 1.2 microns.

Optionally, the spacer layer 105 may be made of an organic planarization material, and the spacer layer 105 can include a first organic layer 05a and a second organic layer 05b that are stacked. The spacer layer 105 is configured to elevate the second light-shielding layer 106, thereby improving the light-shielding effect of the second light-shielding layer 106.

The thickness of the spacer layer 105 ranges from 7 micrometers and 9 micrometers, so as to reduce light leakage between the first light-shielding layer 104 and the second light-shielding layer 106 while ensuring anti-peeping effect. For example, the thickness of the spacer layer 105 may be 7 micrometers, 8 micrometers or 9 micrometers.

Optionally, the thickness of the first organic layer 05a is greater than the thickness of the second organic layer 05b. For example, the thickness of the first organic layer 05a ranges from 4 microns to 5 microns, for example, 4 microns, 4.5 microns or 5 microns. The thickness of the second organic layer 05b ranges from 3 microns to 4 microns, for example, it can be 3 microns, 3.5 microns or 4 microns.

Optionally, the thickness of the protection layer 109 ranges from 3 microns to 5 microns. For example, it can be 3 microns, 4 microns or 5 microns.

Optionally, in some embodiments of the invention, referring to FIG. 4, FIG. 4 a schematic diagram of a partial cross-sectional structure of an edge display region A2 and a central display region A1 in the display panel 100 according to some exemplary embodiments of the invention.

Optionally, the light-emitting pixel layer 102 includes a plurality of pixels, the plurality of pixels includes a plurality of anti-peeping pixels U1 and a plurality of shared pixels U2. The anti-peeping pixels U1 and the shared pixels U2 are arranged alternately along the first direction F1, and the anti-peeping pixels U1 and the shared pixels U2 are arranged alternately along the second direction F2 intersected with the first direction F1.

Optionally, the light-emitting pixel layer 102 includes a plurality of anti-peeping sub-pixels P1 and a plurality of shared sub-pixels P2. The plurality of anti-peeping sub-pixels P1 include first sub-pixels G1, second sub-pixels R1 and third sub-pixels B1 with different light-emitting colors. The plurality of shared sub-pixels P2 include first sub-pixels G1, second sub-pixels R1 and third sub-pixels B1 with different light-emitting colors. Some of the first sub-pixels G1, the second sub-pixels R1 and the third sub-pixels B1 are configured as anti-peeping pixels U1, and the other part of the first sub-pixels G1, the second sub-pixels R1 and the third sub-pixels B1 are configured as shared pixels U2.

Optionally, the first sub-pixels G1 and the second sub-pixels R1 are alternately arranged along the second direction F2 to form a first pixel column, and a plurality of third sub-pixels B1 are arranged along the second direction F2 to form a second pixel column. The first pixel column and the second pixel column are alternately arranged along the first direction F1.

Optionally, the first sub-pixel G1, the second sub-pixel R1 and the third sub-pixel B1 are all rectangles such as right-angled rectangles, chamfered rectangles or rounded rectangles. For example, each of the first sub-pixel G1, the second sub-pixel R1 and the third sub-pixel B1 may be a rectangle or a square.

One of the first sub-pixel G1, the second sub-pixel R1 and the third sub-pixel B1 emits green light; one of them emits red light; and the last one emits blue light. The following description is made by taking an example in which the first sub-pixel G1 emits green light, the second sub-pixel R1 emits red light and the third sub-pixel B1 emits blue light.

It should be noted that, in the anti-peeping mode, only the anti-peeping pixels U1 are lit up in the display panel 100. In the shared mode, only the shared pixels U2 are lit up or both the shared pixels U2 and the anti-peeping pixels U1 of the display panel 100 are lit up.

Each of the anti-peeping pixel U1 and the shared pixel U2 is provided with a center Q. Taking the anti-peeping pixel U1 as an example, the center Q of the anti-peeping pixel U1 is the center point of the pattern formed by the virtual line connecting the centers of the sub-pixels in the anti-peeping pixel. For example, in the anti-peeping pixel U1, virtual lines connecting respective centers of the first sub-pixel G1, the second sub-pixel R1 and the third sub-pixel B1 form a virtual triangle, and the center point of the virtual triangle is the center Q of the anti-peeping pixel U1. The distance from the center Q to each of the centers of the first sub-pixel G1, the second sub-pixel R1 and the third sub-pixel B1 is equal.

Optionally, in some embodiments of the invention, a first number of pixels are respectively disposed in a region between the edge of the second edge region A22 and the boundary of the central display region A1, a region between the edge of the fourth edge region A24 and the boundary of the central display region A1, and a region between the edge of the corner transition region A25 and the boundary of the central display region A1; and the first number ranges from 1 to 30. A second number of pixels are respectively disposed in a region between the edge of the first edge region A21 and the boundary of the central display region A1, and in a region between the edge of the third edge region A23 and the boundary of the central display region A1; and the second number ranges from 1 to 40. A third number of pixels are disposed in a region between the edge of the opening edge region A26 and the boundary of the central display region A1, and the third number ranges from 1 to 20.

It can be understood that, the larger the width of each of the edge regions and transition regions is, the more pixels are provided therein. Thus, the more anti-peeping openings 06a that require lowering compensation, and the greater the lowering extent (inward contraction value) of the anti-peeping opening 06a at the outmost edge, then the smaller the opening width of the anti-peeping opening 06a.

For example, the width of the anti-peeping opening 06a at the outmost edge in the first edge region A21, the width of the anti-peeping opening 06a at the outmost edge in the third edge region A23, the width of the anti-peeping opening 06a at the outmost edge in the second edge region A22, the width of the anti-peeping opening 06a at the outmost edge in the corner transition region A25, and the width of the anti-peeping opening 06a at the outmost edge in the opening edge region A26 may be sequentially increased.

It should be noted that the width of the anti-peeping opening 06a is a width along the first direction F1. Secondly, the anti-peeping opening 06a may be a closed type opening or an open type opening. The invention is described by taking the anti-peeping opening 06a as an open type as an example, but which is not limited thereto.

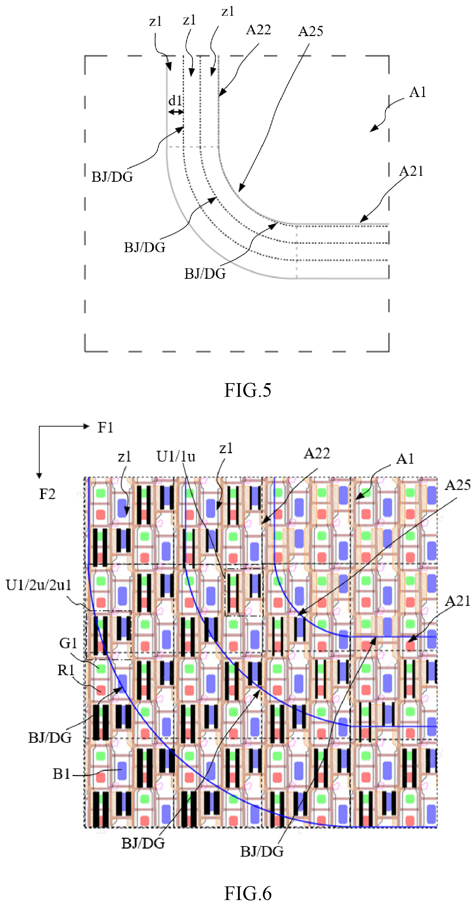

Optionally, in some embodiments of the invention, referring to FIG. 5, the edge display region A2 has a plurality of edge sub-regions z1, and the plurality of edge sub-regions z1 are arranged along a direction from the central display region A1 towards the edge of the edge display region A2. A part of the edge sub-region z1 is located in the first edge region A21, another part of the edge sub-region z1 is located in the corner transition region A25, and a further other part of the edge sub-region z1 is located in the second edge region A22.

In other words, the edge sub-region z1 at least passes through the first edge region A21, the corner transition region A25 and the second edge region A22.

Referring to FIG. 6, the plurality of anti-peeping pixels U1 include at least one first anti-peeping pixel 1u, and the first anti-peeping pixel 1u is completely disposed in one edge sub-region z1. That is, if the anti-peeping pixel U1 is completely disposed in one edge sub-region z1 and not divided by the boundary line BJ of the edge sub-region z1, then the anti-peeping pixel U1 is the first anti-peeping pixel 1u. It should be noted that the anti-peeping pixel U1 being completely disposed in one edge sub-region z1 means that all of the sub-pixels in the anti-peeping pixel U1 fall into the same edge sub-region z1.

In the direction from the central display region A1 to the edge of the edge display region A2, the thickness of the encapsulation layer 103 decreases. In any two adjacent edge sub-regions z1, the width k1 of the anti-peeping opening 06a corresponding to the first anti-peeping pixel 1u in the edge sub-region z1 away from the central display region A1 is smaller than the width k1 of the anti-peeping opening 06a corresponding to the first anti-peeping pixel 1u in the edge sub-region z1 close to the central display region A1; and the widths k1 of the anti-peeping openings 06a corresponding to the first anti-peeping pixels 1u located in the same edge sub-region z1 are the same.

It should be noted that the anti-peeping openings 06a corresponding to the pixel refers to all of the anti-peeping openings 06a in alignment with all the sub-pixels in the pixel in the thickness direction of the display panel 100.

It can be understood that, in the display panel 100 of the embodiments of the invention, the first edge region A21, the corner transition region A25 and the second edge region A22 are regarded as a whole which is divided into a plurality of edge sub-regions z1. The lower the terrain of the edge sub-region z1, the smaller the anti-peeping opening 06a of the first anti-peeping pixel 1u disposed corresponded thereto, and the widths k1 of the anti-peeping openings 06a of the first anti-peeping pixel 1u in the same edge sub-region z1 are the same, so as to improve the uniformity of the display transition between the first edge region A21 and the second edge region A22, and reduce the risk of bright and dark boundary caused by non-uniform transition.

Secondly, the widths k1 of the anti-peeping openings 06a corresponding to the first anti-peeping pixels 1u in the same edge sub-region z1 are the same, so as to reduce the risk that color deviation occurs at a side viewing angle under the anti-peeping mode.

Optionally, in some embodiments of the invention, the widths k1 of all anti-peeping openings 06a in the same anti-peeping pixel U1 are the same, so as to enable the light-emitting angles of the sub-pixels in the anti-peeping pixel U1 to be more consistent, thereby improving display uniformity and reducing risk of color deviation at a side viewing angle.

Optionally, in some embodiments of the invention, in the display panel 100 at a viewing angle of 30 degrees, the anti-peeping pixel U1 located in the central display region A1 has a first light-emitting luminance, the anti-peeping pixel U1 located in the edge display region A2 has a second light-emitting luminance, and the second light-emitting luminance ranges from 80% to 120% of the first light-emitting luminance. For example, the second light-emitting luminous is 80%, 85%, 90%, 95%, 100%, 105%, 110%, 115% or 120% of the first light-emitting luminous.

In the display panel 100 at a viewing angle of 45 degrees, the anti-peeping pixel U1 located in the central display region A1 has a third light-emitting luminance, the anti-peeping pixel U1 located in the edge display region A2 has a fourth light-emitting luminance, and the fourth light-emitting luminance ranges from 90% to 150% of the third light-emitting luminance. For example, the fourth light-emitting luminance is 90%, 95%, 100%, 105%, 110%, 115%, 120%, 125%, 130%, 135%, 140%, 145% or 150% of the third light-emitting luminance.

It can be understood that, in the embodiments of the invention, the lowering compensation is correspondingly performed on the width of the anti-peeping opening 06a in the edge display region A2, so as to reduce the lateral light-emitting luminance of the edge display region A2. For example, compared with the comparative example in which no compensation is performed, at the viewing angle of 30 degrees, the light-emitting luminance of the anti-peeping pixel U1 at the outmost edge is 140% of that of the anti-peeping pixel U1 in the central display region A1, and at the viewing angle of 45 degrees, the light-emitting luminance of the anti-peeping pixel U1 at the outmost edge is 400% of that of the anti-peeping pixel U1 in the central display region A1. In the embodiments of the invention, by performing lowering compensation on the anti-peeping opening 06a corresponding to the anti-peeping pixel U1, the difference in the luminance between the anti-peeping pixels U1 at the outmost edge and the anti-peeping pixels U1 in the central display region A1 at the viewing angle of 30 degrees and the viewing angle of 45 degrees can be significantly reduced, so as to improve light emission uniformity.

Secondly, in order to prevent light leakage at a large viewing angle, as the width of the anti-peeping opening 06a decreases, the width of the anti-peeping portion 061 should be increased synchronously.

Optionally, in some embodiments of the invention, the plurality of anti-peeping pixels U1 include at least one second anti-peeping pixel 2u, and the second anti-peeping pixel 2u is disposed in both two adjacent edge sub-regions z1. The width k1 of the anti-peeping opening 06a corresponding to the first anti-peeping pixel 1u in one of two adjacent edge sub-regions z1 is the same as the width k1 of the anti-peeping opening 06a corresponding to the second anti-peeping pixel 2u.

It should be noted that, if one anti-peeping pixel U1 falls into both two edge sub-regions z1 and is divided by the boundary line BJ of the edge sub-regions z1, then this anti-peeping pixel U1 is the second anti-peeping pixel 2u. It should be noted that the anti-peeping pixel U1 falling into both two edge sub-regions z1 means that a part of all sub-pixels in the anti-peeping pixel U1 fall into one edge sub-region z1, and another part of the sub-pixels fall into another edge sub-region z1. For example, a first sub-pixel G1 and a second sub-pixel R1 in the anti-peeping pixel U1 fall into one edge sub-region z1, and a third sub-pixel B1 falls into another edge sub-region z1. Alternatively, for example, the first sub-pixel G1, the second sub-pixel R1, and a part of the third sub-pixel B1 in the anti-peeping pixel U1 fall into one edge sub-region z1, and another part of the third sub-pixel B1 falls into another edge sub-region z1.

It can be understood that the width of the anti-peeping opening of the second anti-peeping pixel 2u is the same as the width of the anti-peeping opening 06a corresponding to the first anti-peeping pixel 1u in one of two adjacent edge sub-regions z1, so that the widths of the anti-peeping openings 06a decrease in the direction from the central display region A1 to the edge display region A2, so as to improve uniformity in display luminance and uniformity in light-emitting angle.

Optionally, in some embodiments of the invention, the plurality of second anti-peeping pixels 2u include at least one offset anti-peeping pixel 2u1. The center Q of the offset anti-peeping pixel 2u1 is disposed in one edge sub-region z1, and in the same edge sub-region z1, the width of the anti-peeping opening 06a corresponding to the offset anti-peeping pixel 2u1 is the same as the width of the anti-peeping opening 06a corresponding to the first anti-peeping pixel 1u.

It can be understood that, for the edge sub-region z1 which occupies more area of the second anti-peeping pixel 2u (that is, the edge sub-region z1 where the center Q of the second anti-peeping pixel 2u is located), the width of the anti-peeping opening 06a of the first anti-peeping pixel 1u in the edge sub-region z1 which occupies more area of the second anti-peeping pixel 2u (the offset anti-peeping pixel 2u1) is the same as the width of the second anti-peeping pixel 2u (the offset anti-peeping pixel 2u1), so as to reduce the difference in display luminance and light-emitting angle.

Optionally, in some embodiments of the invention, the second anti-peeping pixel 2u includes a middle anti-peeping pixel, and the center Q of the middle anti-peeping pixel is disposed on the boundary line BJ between two adjacent edge sub-regions z1. In two adjacent edge sub-regions z1, the width k1 of the anti-peeping opening 06a corresponding to the first anti-peeping pixel 1u in the edge sub-region z1 away from the central display region A1 is the same as the width k1 of the anti-peeping opening 06a corresponding to the middle anti-peeping pixel.

It can be understood that, based on the fact that the thickness of the film layer under the light-shielding layer ZG corresponding to the anti-peeping opening 06a is in a decreasing trend, and the closer the film layer is to the edge, the greater the decrease extent in thickness. Therefore, the width of the anti-peeping openings 06a of the middle anti-peeping pixel is the same as the width of the anti-peeping openings 06a corresponding to the first anti-peeping pixels 1u in the edge sub-region z1 away from the central display region A1, so as to better reduce difference in the display luminance and the light-emitting angle.

Optionally, in some embodiments of the invention, the second light-shielding layer 106 includes a plurality of anti-peeping portions 061. The plurality of anti-peeping portions 061 are arranged at intervals along the first direction F1 and extend along the second direction F2 intersected with the first direction F1. In the display panel 100 from the top viewing angle, an anti-peeping sub-pixel P1 is disposed between two adjacent anti-peeping portions 061 in the first direction F1. One side of each of two adjacent anti-peeping portions 061 close to the anti-peeping sub-pixel P1 is served as the sidewall of the anti-peeping opening 06a.

In the direction from the central display region A1 to the non-display region NDA of the display panel 100, the widths of the anti-peeping portions 061 located in the edge display region A2 increase.

It can be understood that, as the width of the anti-peeping opening 06a is reduced, the width of the anti-peeping portion 061 increases synchronously to avoid the problem of light leakage at a large viewing angle.

Optionally, in order to prevent light leakage of the anti-peeping pixel U1 without affecting the light emission at large viewing angle of the shared pixel U2, the width of the anti-peeping portion 061 is selected between 6 microns and 8 microns, such as 6 microns, 7 microns or 8 microns.

Optionally, in some embodiments, the plurality of anti-peeping portions 061 include a first anti-peeping portion 61a disposed between the anti-peeping pixel U1 and the shared pixel U2, and a second anti-peeping portion 61b located in the anti-peeping pixel U1 and located between the first sub-pixel G1 and the third sub-pixel B1. The width direction of the anti-peeping portion 061 is the same as the first direction F1.

Optionally, in some embodiments, along the direction from the central display region A1 to the edge of the edge display region A2, in any two adjacent edge sub-regions z1, the width of each of the first anti-peeping portions 61a located at two sides of the first anti-peeping pixel 1u in the edge sub-region z1 away from the central display region A1 is greater than the width of each of the first anti-peeping portions 61a located at two sides of the first anti-peeping pixel 1u in the edge sub-region z1 close to the central display region A1; and the width of the second anti-peeping portion 61b located in the region of the first anti-peeping pixel 1u in the edge sub-region z1 away from the central display region A1 is greater than the width of the second anti-peeping portion 61b located in the region of the first anti-peeping pixel 1u in the edge sub-region z1 close to the central display region A1.

The widths of the second anti-peeping portions 61b in the regions of all the first anti-peeping pixels 1u located in the same edge sub-region z1 are the same. The widths of the first anti-peeping portions 61a on two sides of all the first anti-peeping pixels 1u in the same edge sub-region z1 are the same.

It can be understood that in the same edge sub-region z1, the widths of the second anti-peeping portions 61b in the regions of all the first anti-peeping pixels 1u are the same, and the widths of the first anti-peeping portions 61a on two sides of all the first anti-peeping pixel 1u are also the same. In this way, the widths of the anti-peeping portions 061 can be widened with equal values, and the width of the anti-peeping openings 06a can be reduced synchronously, thereby reducing the risk of light leakage of the first anti-peeping pixel 1u.

In the same edge sub-region z1, the widths of the second anti-peeping portions 61b in the regions of all the first anti-peeping pixel 1u are the same as the widths of the second anti-peeping portions 61b in the region of the offset anti-peeping pixel 2u1; and the widths of the first anti-peeping portions 61a on two sides of all first anti-peeping pixels 1u are the same as the width of the first anti-peeping portions 61a on two sides of the offset anti-peeping pixel 2u1.

It can be understood that in the same edge sub-region z1, the widths of the second anti-peeping portions 61b in the regions of all the first anti-peeping pixel 1u are the same as the widths of the second anti-peeping portions 61b in the region of the offset anti-peeping pixel 2u1; and the widths of the first anti-peeping portions 61a on two sides of all first anti-peeping pixels 1u are the same as the width of the first anti-peeping portions 61a on two sides of the offset anti-peeping pixel 2u1. In this way, the widths of the anti-peeping portions 061 can be widened with equal values, and the widths of the anti-peeping openings 06a can be reduced synchronously, thereby reducing the risk of light leakage of the first anti-peeping pixel 1u and the offset anti-peeping pixel 2u1.

It should be noted that the width of the anti-peeping portion 061 is the width along the first direction F1.

Optionally, in some embodiments of the invention, along the direction from the central display region A1 to the edge of the edge display region A2, the height V1 of the surface of the light-shielding layer ZG having the anti-peeping opening 06a on the side close to the encapsulation layer 103 decreases.

The surface of the light-shielding layer ZG having the anti-peeping opening 06a at the side close to the encapsulation layer 103 has a plurality of contour lines DG, and the boundary line BJ of the edge sub-region z1 is the contour line DG.

It should be noted that the contour line DG is a virtual line.

It can be understood that the edge sub-region z1 is divided in a form of contour line DG, and different contraction values may be designed for the anti-peeping openings 06a in different edge sub-regions z1 according to different height regions. As shown in FIG. 5, from inside to outside, the heights corresponding to the first contour line DG, the second contour line DG and the third contour line DG decrease sequentially. One edge sub-region z1 is formed between the first contour line DG and the second contour line DG, and another edge sub-region z1 is formed between the second contour line DG and the third contour line DG. A first contraction value is set for the edge sub-region z1 between the first contour line DG and the second contour line DG, and a second contraction value is set for the edge sub-region z1 between the second contour line DG and the third contour line DG, and the second contraction value is greater than the first contraction value. In this way, the natural transition of the corner transition region A25 can be improved, so that the uniformity of display luminance is improved.

Optionally, in some embodiments of the invention, in the direction from the central display region A1 to the edge of the edge display region A2, the height of the boundary lines BJ of the edge sub-regions z1 decrease, and two adjacent edge sub-regions z1 share one same boundary line BJ.

It can be understood that the boundary lines BJ of two adjacent edge sub-regions z1 are the same boundary line BJ, so that the arrangement of the edge sub-regions z1 is denser and continuous, thereby improving uniformity of display luminance.

Optionally, in some embodiments of the invention, a height difference is provided between the boundary lines BJ of two adjacent edge sub-regions z1. In the direction from the central display region A1 to the edge of the edge display region A2, the height difference between the boundary lines BJ of any two adjacent edge sub-regions z₁ is the same.

It can be understood that the range of the edge sub-region z1 is limited by a constant height difference, so as to perform inward contraction compensation on the anti-peeping openings 06a of the edge sub-regions z1 in a more regular manner, thereby improving display uniformity.

Optionally, in some embodiments of the invention, a height difference is provided between the boundary lines BJ of two adjacent edge sub-regions z1. Along the direction from the central display region A1 to the edge of the edge display region A2, a height difference between the boundary lines BJ of two adjacent edge sub-regions z1 increases.

It can be understood that, based on the fact that the thickness of the film layer below the light-shielding layer ZG corresponding to the anti-peeping opening 06a presents a decreasing trend, and the closer the film layer is to the edge, the greater the decrease extent in thickness. Therefore, by means of increasing the height difference, the range of the edge sub-region z1 can be limited, so as to reduce the differences between the widths d1 of the edge sub-regions z1, thereby achieving inward contraction compensation for the anti-peeping openings 06a in equivalent width regions, thus improving display uniformity.

Optionally, in some embodiments of the invention, in two adjacent edge sub-regions z1, the width d1 of the edge sub-region z1 away from the central display region A1 is less than the width d1 of the edge sub-region z1 close to the central display region A1.

It can be understood that, based on the fact that the thickness of the film layer below the light-shielding layer ZG corresponding to the anti-peeping opening 06a presents a decreasing trend, and the closer the film layer is to the edge, the greater the decrease extent in thickness. The decrease extent of the thickness of the film layer below corresponding to the edge sub-region z1 closer to the central display region A1 is smaller, so that the difference in the inward contraction compensations of the anti-peeping openings 06a is relatively small. The decrease extent of the thickness of the film layer below corresponding to the edge sub-region z1 away from the central display region A1 is larger, so that the inward contraction compensation for the anti-peeping opening 06a is relatively large. Therefore, the larger width is designed for the edge sub-region z1 with a smaller decrease extent and the smaller width is designed for the edge sub-region z1 with a larger decrease extent, so as to improve the display uniformity.

Optionally, in some embodiments of the invention, in two adjacent edge sub-regions z1, the number of the anti-peeping openings 06a and the number of the anti-peeping sub-pixels P1 in the edge sub-region z1 away from the central display region A1 is less than the number of the anti-peeping openings 06a and the number of the anti-peeping sub-pixels P1 in the edge sub-region z1 close to the central display region A1.

It can be understood that, based on the fact that in two adjacent edge sub-regions z1, the width d1 of the edge sub-region z1 away from the central display region A1 is less than the width d1 of the edge sub-region z1 close to the central display region A1. Therefore, the number of anti-peeping sub-pixels P1 in the edge sub-region z1 away from the central display region A1 is relatively small, and the corresponding number of anti-peeping openings 06a is also relatively small.

Optionally, in some embodiments of the invention, along the first direction F1, the fourth edge region A24 is located at a side of the central display region A1 away from the second edge region A22. In the second direction F2, the third edge region A23 is located at one side of the central display region A1 away from the first edge region A21. The second edge region A22 and the third edge region A23, the third edge region A23 and the fourth edge region A24, and the fourth edge region A24 and the first edge region A21, are respectively connected by the corner transition region A25.

The edge sub-region z1 is a closed ring shape. A first part of the edge sub-region z1 is located at the first edge region A21, a second part of the edge sub-region z1 is located at the second edge region A22, a third part of the edge sub-region z1 is located at the third edge region A23, a fourth part of the edge sub-region z1 is located at the fourth edge region A24, and one fifth part of the edge sub-region z1 is correspondingly located at one corner transition region A25.

It can be understood that, in the embodiments of the invention, four corner transition regions A25 are provided, so that the display luminance at the four edge regions is smoothly transitioned to improve overall display uniformity of the display panel 100.

Optionally, in some embodiments of the invention, the first light-shielding layer 104 is provided with a plurality of first openings 04a. The first opening 04a may be a closed type opening or an open type opening. In the invention, it is taken as an example that the first opening 04a is described as an open type opening, but it is not limited thereto.

In the thickness direction of the display panel 100, one first opening 04a is in alignment with one anti-peeping opening 06a. The first light-shielding layer 104 includes a plurality of first light-shielding portions 041, and the plurality of first light-shielding portions 041 are arranged at interval along the first direction F1 and extend along the second direction F2. In the first direction F1, a side of each of two adjacent first light-shielding portions 041 close to the anti-peeping sub-pixel P1 is defined as the sidewall of the first opening 04a.

The width K2 of the first opening 04a is along the first direction F1. In the direction from the central display region A1 to the edge display region A2, the width K2 of the first opening 04a decreases.

It can be understood that, in the display panel 100 of the embodiments of the invention, based on that fact that the thickness of the encapsulation layer 103 decreases in the direction from the central display region A1 to the non-display region NDA, the width k2 of the first opening 04a is set to decrease along the same direction, so as to correspondingly reduce the light-emitting angle and the lateral light-emitting luminance. In this way, in the anti-peeping mode, differences in light-emitting angles and lateral light emitting luminance of the anti-peeping sub-pixels P1 between the edge display region A2 and the central display region A1 are reduced, thereby improving display uniformity.

Optionally, in some embodiments of the invention, along the direction from the central display region A1 to the non-display region NDA of the display panel 100, in the aligned first opening 04a and the anti-peeping opening 06a, the decrease extent of width of the first opening 04a is the same as that of the anti-peeping opening 06a.

It can be understood that the first opening 04a and the anti-peeping opening 06a in alignment with each other have the same decrease extent, so as to have the same inward contraction value, thereby reducing risk of light leakage from the anti-peeping pixel U1.

Optionally, in some embodiments of the invention, the light-emitting pixel layer 102 includes at least one shared pixel U2, and the shared pixel U2 includes a plurality of shared sub-pixels P2. The first light-shielding layer 104 is provided with a plurality of second openings 04b. The second opening 04b may be a closed type opening or an open type opening. In the invention, it is taken as an example that the first opening 04a is described as an open-type opening, but which is not limited thereto.

In the thickness direction of the display panel 100, one second opening 04b is corresponded to one shared sub-pixel P2.

The width K3 of the second opening 04b is a width along the first direction F1. In the direction from the central display region A1 to the edge display region A2, the width K3 of the second opening 04b decreases.

Optionally, the pixel definition layer 101 is provided with a plurality of second pixel openings S2, and the shared sub-pixel P2 is disposed in the second pixel opening S2.

It can be understood that, in the display panel 100 of the embodiments of the invention, based on that fact that the thickness of the encapsulation layer 103 decreases in the direction from the central display region A1 to the non-display region NDA, the width k3 of the second opening 04b is set to decrease along the same direction, so as to correspondingly reduce the light-emitting angle and the lateral light-emitting luminance. In this way, in the shared mode, differences in light-emitting angles and lateral light emitting luminance of the shared sub-pixels P2 between the edge display region A2 and the central display region A1 are reduced, thereby improving display uniformity.

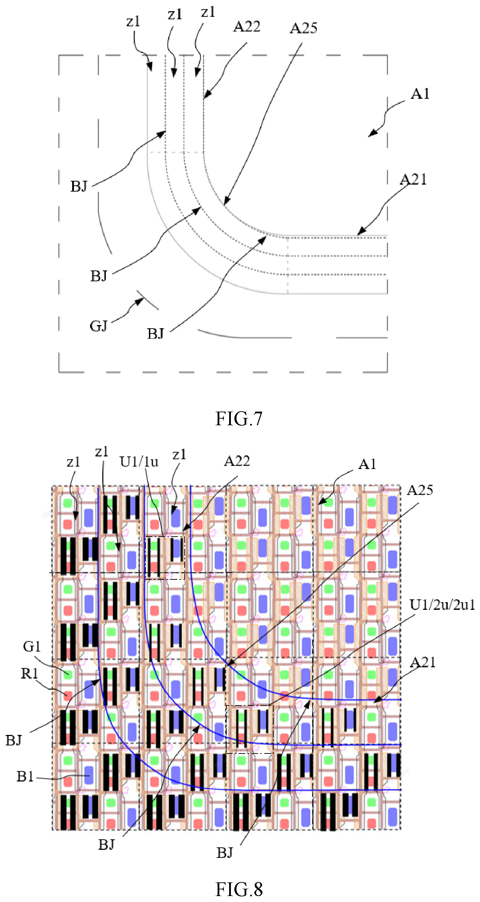

Referring to FIG. 7 and FIG. 8, FIG. 7 is another enlarged schematic diagram of part N in FIG. 1; and FIG. 8 is a partial enlarged schematic diagram of FIG. 7. In FIG. 7 and FIG. 8, the embodiments of the invention will describe parts that are different from those in the above embodiments to avoid redundancy.

Optionally, in some embodiments of the invention, the display panel 100 includes a blocking wall 110, the blocking wall 110 extends along the periphery side of the edge display region A2. The encapsulation layer 103 includes an organic encapsulation layer 03b, the blocking wall 110 is configured to block the organic encapsulation layer 03b, and the side surface of the blocking wall 110 is in contact with the organic encapsulation layer 03b.

In the direction from the central display region A1 to the edge of the edge display region A2, boundary lines BJ of two adjacent edge sub-regions z1 are the same boundary line BJ. The boundary line BJ of the edge sub-region z1 is parallel to the extension trajectory GJ of the blocking wall 110.

It should be noted that the boundary line BJ being parallel to the extension trajectory GJ means that the straight line segment of the boundary line BJ is parallel to the straight line segment of the extension trajectory GJ, and the curved line segment of the boundary line BJ is parallel to the curved line segment of the extension trajectory GJ.

It can be understood that, in the embodiments of the invention, the edge line BI of the edge sub-region z1 is parallel to the extension trajectory GJ of the blocking wall 110, so that the shape of the edge sub-region z1 is similar to the shape of the blocking wall 110, thus, the overall gradient of all anti-peeping openings 06a within the edge sub-region z1 exhibits visual regularity and smooth transition property at the boundary transition region may be improved, thereby improving display uniformity of the entire edge display region A2.

Optionally, in some embodiments of the invention, the width of the first edge region A21 and the width of the second edge region A22 are the same.

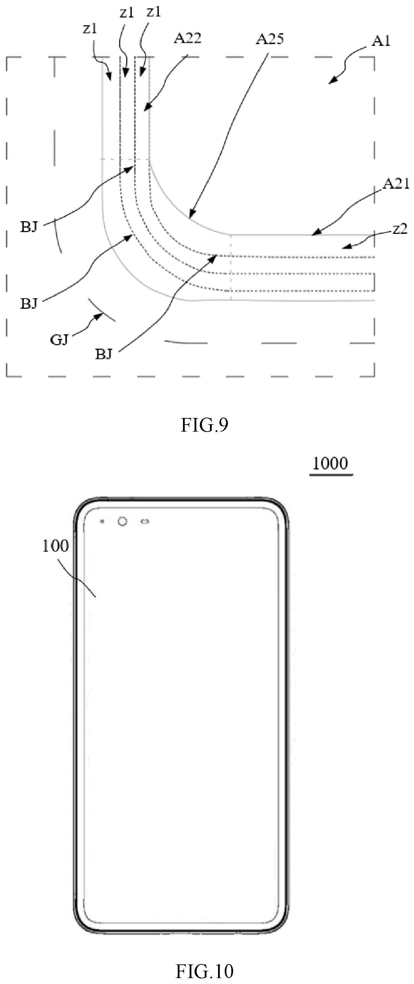

Referring to FIG. 9, and FIG. 9 is another enlarged view of part N in FIG. 1. In FIG. 9, the embodiments of the invention will describe parts that are different from those in the above embodiments to avoid redundancy.

Optionally, in some embodiments of the invention, the width of the first edge region A21 is greater than the width of the second edge region A22. The edge display region A2 further includes an irregularly shaped sub-region z2. A part of the irregularly shaped sub-region z2 is located in the corner transition region A25, and another part of the irregularly shaped sub-region z2 is located in the first edge region A21. The irregularly shaped sub-region z2 is arranged outside the second edge region A22. The irregularly shaped sub-region z2 shares a boundary line BJ with the central display region A1, and the irregularly shaped sub-region z2 shares another boundary line BJ with an adjacent edge sub-region z1. Some of the first anti-peeping pixels 1u of the plurality of anti-peeping pixels U1 are completely disposed in the irregularly shaped sub-region z2.

The width k1 of the anti-peeping opening 06a of the first anti-peeping pixel 1u in the irregularly shaped sub-region z2 is greater than the width k1 of the anti-peeping opening 06a of the first anti-peeping pixel 1u in the edge sub-region z1, and the width of the anti-peeping opening 06a of the first anti-peeping pixel 1u in the irregularly shaped sub-region z2 is less than the width k1 of the anti-peeping opening 06a of the anti-peeping pixel U1 in the central display region A1.

It can be understood that, based on the fact that the width of the first edge region A21 is greater than the width of the second edge region A22, therefore, when the edge sub-regions z1 are formed in sequence by using the virtual lines parallel to the extension trajectory GJ of the blocking wall 110 as the boundary lines BJ of the edge sub-regions z1 and in the direction from the periphery to the central display region A1, the irregularly shaped sub-region z2 is formed by the areas where the first edge region A21 and the corner transition region A25 exceed the second edge region A22. Further, based on the fact that
the irregularly shaped sub-region z2 is connected to the central display region A1, therefore, in the first edge region A21 and the corner transition region A25, the thickness of the film layer below the irregularly shaped sub-region z2 is higher than the thickness of the film layer below the edge sub-region z1, and the decrease extent in the height of the irregularly shaped sub-region z2 is less than the decrease extent in the height of the edge sub-region z1. Therefore, the width k1 of the anti-peeping opening 06a of the first anti-peeping pixel 1u in the irregularly shaped sub-region z2 is designed to be greater than the width k1 of the anti-peeping opening 06a of the first anti-peeping pixel 1u in the edge sub-region z1, and the width of the anti-peeping opening 06a of the first anti-peeping pixel 1u in the irregularly shaped sub-region z2 is less than the width k1 of the anti-peeping opening 06a of the anti-peeping pixel U1 in the central display region A1, so as to achieve a uniform display effect by transitioning between the edge sub-region z1 and the central display region A1.

Optionally, in some embodiments of the invention, some of the second anti-peeping pixels 2u of the plurality of anti-peeping pixels U1 are disposed in both the irregularly shaped sub-region z2 and the edge sub-region z1. The width k1 of the anti-peeping opening 06a of the first anti-peeping pixel 1u in one of the adjacent edge sub-region z1 and the irregularly shaped sub-region z2 is the same as the width k1 of the anti-peeping opening 06a of the second anti-peeping pixel 2u.

It should be noted that the anti-peeping pixel U1 falling into both the edge sub-region z1 and the irregularly shaped sub-region z2 means that a part of all sub-pixels in the anti-peeping pixel U1 fall into the irregularly shaped sub-region z2, and another part of the sub-pixels fall into the edge sub-region z1. For example, the first sub-pixel G1 and the second sub-pixel R1 in the anti-peeping pixel U1 fall into the edge sub-region z1, and the third sub-pixel B1 falls into the irregularly shaped sub-region z2. Alternatively, for example, the first sub-pixel G1, the second sub-pixel R1, and a part of the third sub-pixel B1 in the anti-peeping pixel U1 fall into the edge sub-region z1, and another part of the third sub-pixel B1 falls into the irregularly shaped sub-region z2.

It can be understood that the width of the anti-peeping opening of the second anti-peeping pixel 2u is the same as the width of the anti-peeping opening 06a corresponding to the first anti-peeping pixel 1u in one of the adjacent edge sub-region z1 and the irregularly shaped sub-region z2, so that the widths of the anti-peeping openings 06a decrease in the direction from the central display region A1 to the edge display region A2, so as to improve uniformity in display luminance and uniformity in light-emitting angle.

Optionally, in some embodiments of the invention, the centers Q of some of the offset anti-peeping pixels 2u1 are disposed in the edge sub-region z1, and in the same edge sub-region z1, the width of the anti-peeping opening 06a of the offset anti-peeping pixel 2u1 is the same as the width of the anti-peeping opening 06a of the first anti-peeping pixel 1u.

The centers Q of some of the offset anti-peeping pixels 2u1 are disposed in the irregularly shaped sub-region z2, and in the irregularly shaped sub-region z2, the width of the anti-peeping opening 06a of the offset anti-peeping pixel 2u1 is the same as the width of the anti-peeping opening 06a of the first anti-peeping pixel 1u.

It can be understood that, for the edge sub-region z1 which occupies more area of the second anti-peeping pixel 2u (that is, the edge sub-region z1 where the center Q of the second anti-peeping pixel 2u is located), the width of the anti-peeping opening 06a of the first anti-peeping pixel 1u in the edge sub-region z1 which occupies more area of the second anti-peeping pixel 2u (the offset anti-peeping pixel 2u1) is the same as the width of the second anti-peeping pixel 2u (the offset anti-peeping pixel 2u1), so as to reduce the difference in display luminance and light-emitting angle.

Optionally, in some embodiments of the invention, the centers Q of some of a plurality of middle anti-peeping pixels are disposed on the boundary line BJ between the adjacent irregularly shaped sub-region z2 and an edge sub-region z1. In the adjacent irregularly shaped sub-region z2 and edge sub-region z1, the width k1 of the anti-peeping opening 06a of the first anti-peeping pixel 1u in the edge sub-region z1 is the same as the width k1 of the anti-peeping opening 06a of the middle anti-peeping pixel.

It can be understood that, based on the fact that the thickness of the film layer under the light-shielding layer ZG corresponding to the anti-peeping opening 06a is in a decreasing trend, and the closer the film layer is to the edge, the greater the decrease extent in thickness. Therefore, the widths of the anti-peeping openings 06a corresponding to the middle anti-peeping pixel and corresponding to the first anti-peeping pixel 1u in the edge sub-region z1 away from the central display region A1 are designed to be the same, so as to better reduce the difference in the display luminance and the light-emitting angle.

It should be noted that the first anti-peeping pixel 1u is an anti-peeping pixel U1 completely falling into a unique sub-region, for example, the anti-peeping pixel U1 completely falling into the edge sub-region z1 and the anti-peeping pixel U1 completely falling into the irregularly shaped sub-region z2 are both the first anti-peeping pixels 1u. The second anti-peeping pixel 2u is an anti-peeping pixel U1 that falls into both two sub-regions, for example, the anti-peeping pixel U1 that falls into both two edge sub-regions z1 and the anti-peeping pixel U1 that falls into both one edge sub-region z1 and one irregularly shaped sub-region z2 are both the second anti-peeping pixels 2u. The middle anti-peeping pixel is a second anti-peeping pixel 2u whose center falls exactly on the common boundary line of two sub-regions. The offset anti-peeping pixel 2u1 is a second anti-peeping pixel 2u whose center falls within one sub-region, therefore, if an offset anti-peeping pixel 2u1 is disposed in a sub-region, then the center of this offset anti-peeping pixel falls within said sub-region.

Referring to FIG. 10, FIG. 10 is a schematic diagram of a structure of a display device 1000 according to some embodiments of the invention. According to a second aspect of the invention, a display device 1000 is provided, which includes the display panel 100 in any one of the embodiments described above.

It should be noted that the structure of the display panel 100 of the display device 1000 provided by the embodiments of the invention is the same as the structure of the display panel 100 provided by the embodiments described above, and specific descriptions may refer to relevant descriptions in FIG. 1 to FIG. 9, which are not described herein again.

The display device 1000 may be at least one of a smart phone, a tablet computer, a mobile phone , a video phone, an e-book reader, a desktop computer, a laptop PC, a netbook computer, a workstation, a server, a personal digital assistant, a portable multimedia player, a MP3 player, a television, a mobile medical device, a camera, a game console, a digital camera, a car navigator, a car display, an electronic billboard, an automatic teller machine, a wearable device, a VR device and an AR device.

In the display device 1000 of embodiments of the invention, the edge display region A2 is provided with a plurality of edge sub-regions z1. The plurality of edge sub-regions z1 are arranged along a direction from the central display region A1 to the edge of the edge display region A2. A part of one of the edge sub-regions z1 is located in the first edge region A21, another part of the edge sub-region z1 is located in the corner transition region A25; and a further other part of the edge sub-region z1 is located in the second edge region A22.

The anti-peeping pixels U1 include at least one first anti-peeping pixel 1u, the first anti-peeping pixel 1u is completely disposed in one edge sub-region z1. In the direction from the central display region A1 to the edge of the edge display region A2, the thickness of the encapsulation layer 103 decreases. In any two adjacent edge sub-regions z1, the width k1 of the anti-peeping opening 06a of the first anti-peeping pixel 1u in the edge sub-region z1 away from the central display region A1 is smaller than the width of the anti-peeping opening 06a of the first anti-peeping pixel 1u in the edge sub-region z1 close to the central display region A1; and the widths k1 of the anti-peeping openings 06a of the first anti-peeping pixels 1u located in the same edge sub-region z1 are the same.

It can be understood that, in the display panel 100 and the display device 1000 of the embodiments of the invention, the first edge region A21, the corner transition region A25 and the second edge region A22 are regarded as a whole which is divided into a plurality of edge sub-regions z1. The lower the terrain of the edge sub-region z1, the smaller the anti-peeping opening 06a of the first anti-peeping pixel 1u disposed corresponded thereto, and the widths k1 of the anti-peeping openings 06a of the first anti-peeping pixel 1u in the same edge sub-region z1 are the same, so as to improve the uniformity of the display transition between the first edge region A21 and the second edge region A22, and reduce the risk of bright and dark boundary caused by non-uniform transition.

In the description of the invention, the terms "first" and "second" are used only for descriptive purposes and should not be understood as indicating or implying relative importance or the number of indicated technical features. Thus, features defined with "first" and "second" may explicitly or implicitly include one or more of the feature. In the description of this disclosure, the term "multiple" refers to two or more, unless otherwise specifically limited.

In the foregoing embodiments, the descriptions of each embodiment have their own emphasis, and for parts not described in detail in a certain embodiment, reference may be made to relevant descriptions of other embodiments.

The embodiments, implementations and related technical features of the invention can be combined and replaced with each other without conflict.

What described above are only preferred embodiments of the invention and are not intended to limit the invention in any form. Any modification, equivalent change or embellishment to the above embodiments based on the technical concepts of the invention without departing from the content of the invention shall still fall within the scope of the invention.

## Claims

1. A display panel (100), **characterized by** comprising:
a light-emitting pixel layer (102) comprising a plurality of anti-peeping pixels (U1), wherein each of the anti-peeping pixels (U1) comprises a plurality of anti-peeping sub-pixels (P1);
an encapsulation layer (103) covering a light-emitting side of the light-emitting pixel layer (102); and
at least one light-shielding layer (ZG) disposed on a side of the encapsulation layer (103) away from the light-emitting pixel layer (102), wherein one of the at least one light-shielding layer (ZG) is configured to shield part of emitted light of the anti-peeping sub-pixels (P1), and the light-shielding layer (ZG) is provided with a plurality of anti-peeping openings (06a), each of the anti-peeping sub-pixels (P1) is corresponded to one of the anti-peeping openings (06a), and a width of each of the anti-peeping openings (06a) is a dimension along a first direction (F1);
wherein the display panel (100) comprises a central display region (A1) and an edge display region (A2), the edge display region (A2) is disposed at a periphery of the central display region (A1), the edge display region (A2) comprises a first edge region (A21), a second edge region (A22), and at least one corner transition region (A25); wherein the first edge region (A21) extends along the first direction (F1) and is located at one side of the central display region (A1) in a second direction (F2), the second edge region (A22) extends along the second direction (F2) and is located at one side of the central display region (A1) in the first direction (F1), the corner transition region (A25) connects the first edge region (A21) with the second edge region (A22), and the first direction (F1) is intersected with the second direction (F2);
wherein the edge display region (A2) comprises a plurality of edge sub-regions (z1), the edge sub-regions (z1) are arranged along a direction from the central display region (A1) to an edge of the edge display region (A2), a part of one of the edge sub-regions (z1) is located in the first edge region (A21), another part of the edge sub-region is located in the corner transition region (A25), and a further other part of the edge sub-region (z1) is located in the second edge region (A22); and
wherein the anti-peeping pixels (U1) comprise a plurality of first anti-peeping pixels (1u), each of the first anti-peeping pixels (1u) is completely disposed in one of the edge sub-regions (z1); wherein a thickness of the encapsulation layer (103) decreases in the direction from the central display region (A1) to the edge of the edge display region (A2), and in any two adjacent ones of the edge sub-regions (z1), a width of an anti-peeping opening (06a) corresponding to one of the first anti-peeping pixels (1u) in one of the two adjacent edge sub-regions (z1) away from the central display region (A1) is smaller than a width of an anti-peeping opening (06a) corresponding to one of the first anti-peeping pixels (1u) in one of the two adjacent edge sub-regions (z1) close to the central display region (A1), and widths of anti-peeping openings (06a) corresponding to ones of the first anti-peeping pixels (1u) located in a same one of the edge sub-regions (z1) are same.

2. The display panel (100) according to claim 1, wherein the anti-peeping pixels (U1) comprise a plurality of second anti-peeping pixels (2u), wherein each of the second anti-peeping pixels (2u) is disposed in both two adjacent ones of the edge sub-regions (z1), and a width of an anti-peeping opening (06a) corresponding to one of the first anti-peeping pixels (1u) in one of the two adjacent edge sub-regions (z1) is same as a width of an anti-peeping opening (06a) corresponding to the second anti-peeping pixel (2u).

3. The display panel (100) according to claim 2, wherein the second anti-peeping pixels (2u) comprise an offset anti-peeping pixel (2u1), a center (Q) of the offset anti-peeping pixel (2u1) is disposed in one of the two adjacent edge sub-regions (z1), and in the same edge sub-region (z1), a width of an anti-peeping opening (06a) corresponding to the offset anti-peeping pixel (2u1) is same as the width of the anti-peeping opening (06a) corresponding to the first anti-peeping pixel (1u); or
wherein the second anti-peeping pixels (2u) comprise a middle anti-peeping pixel, and a center (Q) of the middle anti-peeping pixel is disposed on a boundary line (BJ) between the two adjacent edge sub-regions (z1); in the two adjacent edge sub-regions (z1), a width of an anti-peeping opening (06a) corresponding to one of the first anti-peeping pixels (1u) in one of the two adjacent edge sub-regions (z1) away from the central display region (A1) is same as a width of an anti-peeping opening (06a) corresponding to the middle anti-peeping pixel.

4. The display panel (100) according to claim 1, wherein a height of a surface on a side of the light-shielding layer (ZG) provided with the anti-peeping openings (06a) close to the encapsulation layer (103) decreases along the direction from the central display region (A1) to the edge of the edge display region (A2); and
wherein the surface on the side of the light-shielding layer (ZG) provided with the anti-peeping openings (06a) close to the encapsulation layer (103) has a plurality of contour lines (DG), and boundary lines (BJ) of the edge sub-regions (z1) are the contour lines (DG).

5. The display panel (100) according to claim 4, wherein heights of the boundary lines (BJ) of the edge sub-regions (z1) decrease in the direction from the central display region (A1) to the edge of the edge display region (A2); and two adjacent ones of the edge sub-regions (z1) have a same boundary line (BJ).

6. The display panel (100) according to claim 5, wherein two adjacent ones of the boundary lines of the edge sub-regions (z1) has a height difference, and a height difference between any two ones of the boundary lines (BJ) of the edge sub-regions (z1) is consistent in the direction from the central display region (A1) to the edge of the edge display region (A2); or,
wherein two adjacent ones of the boundary lines (BJ) of the edge sub-regions (z1) has a height difference, and the height difference between the two adjacent boundary lines (BJ) of the edge sub-regions (z1) increases in the direction from the central display region (A1) to the edge of the edge display region (A2).

7. The display panel (100) according to claim 1, wherein the display panel (100) comprises a blocking wall (110), the blocking wall (110) extends along a periphery of the edge display region (A2), the encapsulation layer (103) comprises an organic encapsulation layer (03b), and the blocking wall (110) is configured to block the organic encapsulation layer (03b); and
wherein in the direction from the central display region (A1) to the edge of the edge display region (A2), two adjacent ones of the edge sub-regions (z1) have a same boundary line (BJ), and the boundary line (BJ) of the two adjacent edge sub-regions (z1) is parallel to an extension trajectory of the blocking wall (110).

8. The display panel (100) according to claim 7, wherein a width of the first edge region (A21) is greater than a width of the second edge region (A22), and the edge display region (A2) further comprises an irregularly shaped sub-region (z2); wherein a part of the irregularly shaped sub-region (z2) is located in the corner transition region (A25), another part of the irregularly shaped sub-region (z2) is located in the first edge region (A21), and the irregularly shaped sub-region (z2) is disposed outside the second edge region (A22); wherein the irregularly shaped sub-region (z2) shares a boundary line (BJ) with the central display region (A1), and the irregularly shaped sub-region (z2) shares another boundary line (BJ) with an adjacent one of the edge sub-regions (z1), and some of the first anti-peeping pixels (1u) of the anti-peeping pixels (U1) are completely disposed in the irregularly shaped sub-region (z2); and
wherein a width of an anti-peeping opening (06a) corresponding to one of the first anti-peeping pixels (1u) in the irregularly shaped sub-region (z2) is greater than a width of an anti-peeping opening (06a) corresponding to one of the first anti-peeping pixels (1u) in the edge sub-regions (z1), and the width of the anti-peeping opening (06a) corresponding to the first anti-peeping pixel (1u) in the irregularly shaped sub-region (z2) is less than a width of an anti-peeping opening (06a) corresponding to one of the anti-peeping pixels (U1) in the central display region (A1).

9. The display panel (100) according to any one of claims 1 to 8, wherein in two adjacent ones of the edge sub-regions (z1), a width of one of the two adjacent edge sub-regions (z1) away from the central display region (A1) is less than a width of one of the two adjacent edge sub-regions (z1) close to the central display region (A1).

10. The display panel (100) according to claim 9, wherein in the two adjacent edge sub-regions (z1), a number of anti-peeping openings (06a) and a number of anti-peeping sub-pixels (P1) in one of the two adjacent edge sub-regions (z1) away from the central display region (A1) is less than a number of anti-peeping openings (06a) and a number of anti-peeping sub-pixels (P1) in one of the two adjacent edge sub-regions (z1) close to the central display region (A1).

11. The display panel (100) according to any one of claims 1 to 8, wherein the edge display region (A2) comprises a third edge region (A23) and a fourth edge region (A24); wherein the third edge region (A23) extends along the first direction (F1), and the fourth edge region (A24) extends along the second direction (F2);
wherein the fourth edge region (A24) is located at a side of the central display region (A1) away from the second edge region (A22) in the first direction (F1), the third edge region (A23) is located at a side of the central display region (A1) away from the first edge region (A21) in the second direction (F2); wherein the second edge region (A22) and the third edge region (A23), the third edge region (A23) and the fourth edge region (A24), and the fourth edge region (A24) and the first edge region (A21), are respectively connected by one of the at least one corner transition region (A25); and
wherein one of the edge sub-regions (z1) is a closed ring shape, a first part of the edge sub-region (z1) is located in the first edge region (A21), a second part of the edge sub-region (z1) is located in the second edge region (A22), a third part of the edge sub-region (z1) is located in the third edge region (A23), a fourth part of the edge sub-region (z1) is located in the fourth edge region (A24), and one fifth part of the edge sub-region (z1) is correspondingly located in one of the at least one corner transition region (A25).

12. The display panel (100) according to any one of claims 1 to 8, wherein the display panel (100) comprises a spacer layer (105), the at least one light-shielding layer (ZG) comprises a first light-shielding layer (104) and a second light-shielding layer (106), the first light-shielding layer (104) is disposed on a side of the encapsulation layer (103) away from the light-emitting pixel layer (102), the first light-shielding layer (104) is configured to block part of the emitted light of the anti-peeping sub-pixels (P1); wherein the spacer layer (105) covers a side of the first light-shielding layer (104) away from the light-emitting pixel layer (102); the second light-shielding layer (106) is disposed on a surface at a side of the spacer layer (105) away from the light-emitting pixel layer (102), and the second light-shielding layer (106) is provided with the anti-peeping openings (06a); and
wherein the first light-shielding layer (104) is provided with a plurality of first openings (04a), one of the first openings (04a) is correspondingly aligned with one of the anti-peeping openings (06a) in a thickness direction of the display panel (100), and a width of each of the first openings (04a) is along the first direction (F1); wherein widths of the first openings (04a) decrease in the direction from the central display region (A1) to the edge display region (A2).

13. The display panel (100) according to claim 12, wherein in the first opening (04a) and the anti-peeping opening (06a) which are aligned with each other, a decrease extent in width of the first opening (04a) is same as a decrease extent in width of the anti-peeping opening (06a) in a direction from the central display region (A1) to a non-display region (NDA) of the display panel (100).

14. The display panel (100) according to claim 12, wherein the light-emitting pixel layer (102) comprises a shared pixel (U2), wherein the shared pixel (U2) comprises a plurality of shared sub-pixels (P2), the first light-shielding layer (104) is provided with a plurality of second openings (04b), and one of the second openings (04b) is corresponded to one of the shared sub-pixels (P2) in a thickness direction of the display panel (100); and
wherein a width of each of the second openings (04b) is along the first direction (F1), and the width of the second opening (04b) decreases in the direction from the central display region (A1) to the edge display region (A2).

15. A display device (1000), **characterized by** comprising the display panel (100) according to any one of claims 1 to 14.
